# EUROPÄISCHE PATENTANMELDUNG

(11) **EP 0 770 702 A1**
(43) Veröffentlichungstag der Anmeldung: **02.05.1997**
(21) Anmeldenummer: 96116382.1
(22) Anmeldetag: 12.10.1996
(51) Int. Cl.: C23C 14/48, C23C 16/14, C23C 8/10, C22C 1/04

(54) **Verfahren zur Erhöhung der Korrosionsbeständigkeit von Legierungen auf der Basis TiAl**

(30) Priorität: 23.10.1995 DE 19539303; 23.10.1995 DE 19539305; 09.07.1996 DE 19627605
(71) Anmelder: DECHEMA Deutsche Gesellschaft für Chemisches Apparatewesen, Chemische Technik und Biotechnologie e.V., D-60486 Frankfurt (DE)
(72) Erfinder: Schütze, Michael, Dr.-Ing., 63741 Aschaffenburg (DE); Hald, Martin, Dipl.-Ing., 73479 Ellwangen (DE)
(74) Vertreter: Schlagwein, Udo, Dipl.-Ing.

(57) **Zusammenfassung**

Bei einem Verfahren zur Erhöhung der Korrosionsbeständigkeit von Legierungen auf der Basis TiAl werden Halogene und oder halogenhaltige Verbindungen über die Gasphase oder Flüssigkeitsphase zumindest auf die Werkstoffoberfläche übertragen. Dadurch erhöht sich die Korrosionsbeständigkeit bis wenigstens zu Temperaturen von 900°C, ohne dass die mechanische Festigkeit der Legierungen sich verschlechtert.

## Beschreibung

Die Erfindung betrifft ein Verfahren zur Erhöhung der Korrosionsbeständigkeit von Legierungen auf der Basis TiAl.

TiAl-Legierungen sind aufgrund ihres geringen spezifischen Gewichtes und der Warmfestigkeit insbesondere für alle Anwendungen bei hohen Temperaturen von Interesse, bei denen Bauteile ein geringes Eigengewicht besitzen sollen. Beispiele hierfür sind Turbinenschaufeln in Flugtriebwerken sowie in stationären Gasturbinen, Turboladerrotoren und Ventile bei PKW-Motoren sowie Heißgasventilatoren. Ein Problem stellt allerdings nach wie vor die geringe Oxidationsbeständigkeit dieser Legierungen bei Temperaturen oberhalb von 700°C dar (A. Rahmel, W.J. Quadakkers, M. Schütze: Werkstoffe und Korrosion 46 (1995) 271-285). Daher wurden verschiedentlich Legierungsmaßnahmen getroffen, die über die Zugabe von Elementen wie Niob, Wolfram, Molybdän und Silicium eine Erhöhung der Oxidationsbeständigkeit bewirken können (Y. Shida, H. Anada: Materials Transactions JIM 9 (1994) 623-631). Diese Elemente besitzen allerdings den Nachteil, dass sie die mechanischen Eigenschaften negativ beeinflussen. Elemente wie Mangan, Chrom oder Bor, die wiederum positiv auf die mechanischen Eigenschaften wirken, führen dagegen zu einer Verschlechterung der Oxidationsbeständigkeit bei hohen Temperaturen. Die Folge ist, dass bisher der Einsatz von TiAl-Legierungen auf Temperaturen bis maximal 700°C begrenzt ist. Neben reinen Legierungsmaßnahmen wurden auch andere Wege vorgeschlagen, um die Oxidationsbeständigkeit zu verbessern. Eine Methode beruht darauf, dass eine Wärmebehandlung durchgeführt wird, bei der sich eine lamellare, eutektoide Ti₃Al/TiAl-Struktur an der Oberfläche einstellt (W.J. Quadakkers, A. Gil: DE 42 15 017 AL). Ein anderer Weg führt über das Zumischen von feinen Al₂O₃-Pulvern bei der Herstellung von TiAl-Legierungen auf dem pulvermetallurgischen Wege (K. Shibue: EP 0 495 454 A2).

Der Erfindung liegt das Problem zugrunde, ein Verfahren zu entwickeln, bei dem TiAl-Legierungen durch Zugabe von anderen Stoffen hinsichtlich ihrer Korrosionsbeständigkeit bei Temperaturen bis 900 °C auch über längere Einsatzzeiträume erhöht werden, ohne dass sich die Festigkeit der Legierung verschlechtert.

Die Lösung der Aufgabe geschieht grundsätzlich mit den Merkmalen aus dem kennzeichnenden Teil des Patentanspruchs 1. Vorteilhafte Ausführungsformen sind in den Unteransprüchen beschrieben.

Der Grundgedanke der Erfindung besteht darin, dass ein Werkstoff in einer korrosiv wirkenden Umgebung bei hohen Temperaturen nur dann beständig ist, wenn bei Reaktion mit der Umgebung sehr dünne, dichte und äußerst langsam wachsende Korrosionsproduktschichten gebildet werden, die eine Barrierewirkung zwischen der äußeren Umgebung und dem Metall entwickeln. Bei Anwesenheit von Sauerstoff in der Umgebung bilden Legierungen auf der Basis TiAl in der Regel Oxide von beiden Legierungselementen, d.h. Titanoxid und Aluminiumoxid. Während Aluminiumoxid unter diesen Bedingungen ein sehr langsam wachsendes Korrosionsprodukt darstellt, findet bei der Bildung von Titanoxid ein sehr schnelles Wachstum der Korrosionsproduktschichten und damit ein beschleunigter Metallverbrauch des Bauteils statt. Dünne Korrosionsproduktschichten lassen sich auf TiAl-Legierungen daher nur erzielen, wenn das schnelle Wachstum der Titanoxide auf der Werkstoffoberfläche verhindert werden kann. Dies ist im wesentlichen dadurch möglich, dass sich eine geschlossene Aluminiumoxid-(Teil-)Deckschicht durch die Oxidationsreaktion mit der Umgebung bildet.

In der Literatur finden sich Beobachtungen, dass der Herstellungsweg der Titanaluminide einen signifikanten Einfluss auf die Geschwindigkeit der Korrosionsreaktion haben kann (K. Shibue, M. Kumagai, M.-S. Kim: J. Japan Inst. Metals 56 (1992) 1457-1462). So wird im Falle einer aus Metallpulvern reaktionsgesinterten TiAl-Legierung gefunden, dass die Oxidationsgeschwindigkeit bei 950°C an Luft um ca. 2 Größenordnungen niedriger liegt als bei einer Legierung, die dem Schmelzprozess unterworfen gewesen war. Die Mechanismen und der ursächliche Zusammenhang sind in diesem Fall allerdings nicht bekannt. Von den Erfindern wurde jedoch vermutet, dass bei der reaktionsgesinterten Variante chloridhaltige Verunreinigungen im Ausgangspulver zu dem beobachteten Effekt geführt haben. Durch die schmelzmetallurgische Behandlung wurden die bei hohen Temperaturen leichtflüchtigen Chloride ausgetrieben, so dass sie ihren positiven Effekt für die Oxidationsbeständigkeit der Legierung nicht mehr entfalten können. Versuche, in denen auf die Werkstoffoberfläche Natriumsulfat, Natriumchlorid, Manganchlorid, Zinkfluorid oder Silberbromid durch Eintauchen in eine wässrige Lösung aufgebracht wurden und anschließend eine Erwärmung des Werkstoffs auf 950°C erfolgte, führten zu einer offensichtlichen Verbesserung der Oxidationsbeständigkeit (M. Kumagai, K. Shibue, M.-S. Kim: J. Japan Inst. Metals 57 (1993) 721-725). In den eigenen Untersuchungen wurden dagegen Halogenide über die Gasphase auf die Werkstoffoberfläche bei erhöhten Temperaturen aufgebracht. Anschließende Versuche zur Oxidationsbeständigkeit der so vorbehandelten Werkstoffe, die mindestens bis 1000 Stunden bei 900°C durchgeführt wurden, zeigten, dass nach einer kurzen Anfangsphase quasi ein Stillstand der Korrosionsreaktion eintritt. Die Halogene bzw. halogenhaltigen Verbindungen können einerseits durch die Einbringung eines definierten Gases in den Reaktor bereitgestellt werden oder andererseits über einen thermischen Verdampfungs- oder Zersetzungsprozess von festen halogenhaltigen Phasen am Eingang oder innerhalb des Reaktors zur Verfügung stehen. Zum Transport der halogenhaltigen Spezies kann ein Trägergas verwendet werden, das entweder als Schutzgas (z.B. Argon) oder in Verbindung mit einem Voroxidationsprozess als sauerstoffhaltiges Gas (z.B. Luft) vorliegt.

Es ist möglich, dass bei diesem Verfahren lose anhaftende halogenhaltige Reaktionsprodukte auf der Werkstoffoberfläche entstehen, die durch leichtes Abbürsten nach dem Prozess entfernt werden sollten. Das Ergebnis der Werkstoffoberflächenbehandlung mit dem beschriebenen Verfahren ist, dass zwar in der Anfangsphase der Korrosion des späteren Hochtemperatureinsatzes der Werkstoffe sowohl das schnellwachsende nichtschützende Titanoxid als auch das langsamwachsende schützende Aluminiumoxid gleichzeitig entstehen können; nach einer kurzen Inkubationszeit bildet sich aber dann eine geschlossene Aluminiumoxidteildeckschicht in der Oxidschicht auf dem Werkstoff aus, die den Korrosionsprozess auf sehr niedrige Geschwindigkeiten verlangsamt und somit den korrosionsbedingten Metallabtrag signifikant reduziert. Diese Wirkung erlaubt den langzeitigen Einsatz von TiAl-Legierungen auch bei Temperaturen oberhalb von 700°C, ohne dass es zu einer schnellen Abnahme des tragenden Metallquerschnitts durch die Korrosionsreaktion kommt.

### Beispiel:

In einem Rohrreaktor mit einem Trennsteg wurden eine Probe aus dem Werkstoff TiAl48Cr2 (48 at.-% Aluminium, 2 at.-% Chrom, Rest Titan und Verunreinigungen, entsprechend 63,4 Gewicht-% Titan, 33,4 Gewicht-% Aluminium und 2,9 Gewicht-% Chrom) und pulverförmiges Natriumchlorid bei 790°C geglüht. Der Glassteg unterteilt den Reaktor und trennt das Natriumchlorid in der einen Hälfte des Reaktors von der Probe in der anderen Hälfte. Der offene Rohrquerschnitt über dem Steg lässt einen freien Gasaustausch zu. Das Natriumchlorid (Natriumchlorid p.a., Gehalt min. 99,5 %) wurde 5 h bei 150°C im Trockenschrank vorgetrocknet. Die Probe aus TiAl48Cr2 war durch Verdüsen der Schmelze und Kompaktieren des auf diese Weise erzeugten Pulvers mittels heiß isostatischem Pressen hergestellt worden. Die Oberfläche der Probe wurde mit Schleifpapier bis zu einer Körnung von 1000 präpariert und nach einer Reinigung mit Alkohol in den Reaktor eingegeben. Der Reaktor wurde unter Normaldruck und an Luft verschlossen. Die Glühung der Probe in Anwesenheit des Natriumchloridpulvers erfolgte im Reaktor für 150 h bei 790°C. Die Probe besitzt nach der Glühung ein lokal unterschiedliches Aussehen. Es bildet sich flächenhaft eine dünne, hoch aluminiumhaltige Schicht, die sich zum Teil ablöst. Besonders an Kanten kommt es zur Bildung von Kristallen, in denen Titan, Natrium und Chlor nachgewiesen werden können. Nach der Behandlung der Proben mit dem beschriebenen Verfahren wurden alle lose anhaftenden Produkte auf der Oberfläche abgebürstet, bis sich ein metallischer Glanz einstellte.

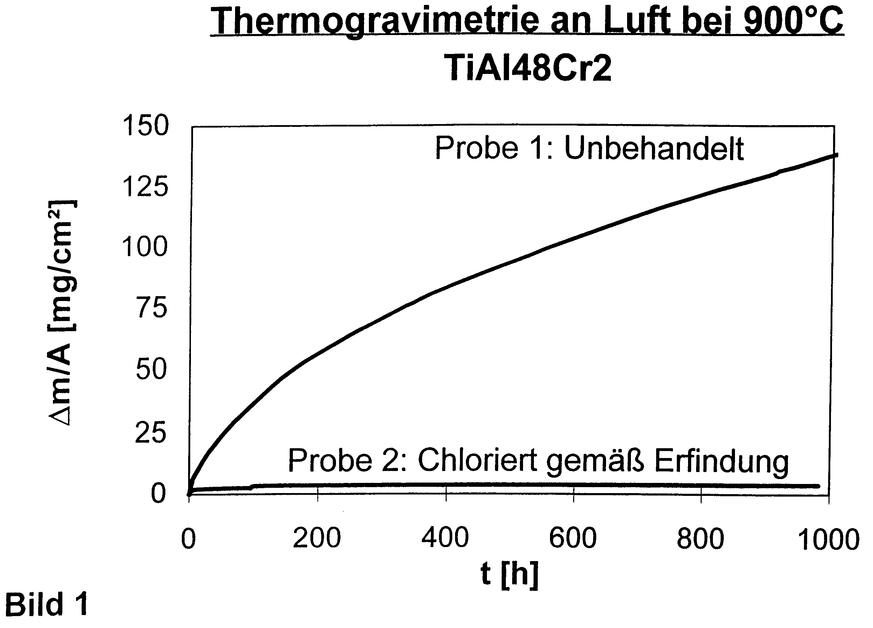

Anschließend wurde zur Prüfung der Oxidationsbeständigkeit ein Oxidationsversuch an Luft bei 900°C durchgeführt, in dem eine kontinuierliche Messung der Massenzunahme erfolgte. Die Aufheizrate auf die isotherme Oxidationstemperatur betrug 10 K/min. In Bild 1 sind die Massenzunahmen als Folge der Oxidation bei 900°C an Luft von Proben mit und ohne Vorbehandlung gemäß der Erfindung aufgetragen. Die Probe 1 ohne Vorbehandlung zundert stark und besitzt eine flächenbezogene Massenzunahme von 138 mg/cm² nach 1000 h. Die Probe 2 mit der Vorbehandlung weist eine anfängliche flächenbezogene Massenzunahme von 2,4 mg/cm² nach 20 h auf. Nach 100 h wurde die behandelte Probe einmalig abgekühlt und wieder auf isotherme Glühtemperatur aufgeheizt. Die flächenbezogene Massenzunahme nimmt beim Wiederaufheizen zu, um dann mindestens bis zu 1000 h praktisch zu stagnieren. Dieses Oxidationsverhalten entspricht dem einer Deckschicht mit Barrierewirkung und steht für eine ausgeprägte Oxidationsbeständigkeit des Werkstoffs. Nach 1000 h bei 900°C an Luft beträgt die flächenbezogene Massenzunahme nur 3,8 mg/cm². Es kommt somit durch die Behandlung gemäß dem Verfahren der Erfindung zu einer signifikanten Verbesserung des Oxidationsverhaltens unter isothermen und thermozyklischen Bedingungen.

Statt nur die Werkstoffoberfläche den Halogenen oder halogenhaltigen Verbindungen auszusetzen, kann man gemäß einer Weiterbildung der Erfindung auch vorsehen, dass diese Stoffe während eines pulvermetallurgischen Herstellungsprozesses der Legierung in den Werkstoff eingebracht werden und eines oder mehrere der Ausgangs- bzw. Legierungspulver der Halogenierung über die Gasphase oder Flüssigkeitsphase unterzogen werden.

In der Literatur finden sich Beobachtungen, dass bei der Herstellung der Titanaluminide unter Verwendung von Ti-Pulver aus dem Hunter-Prozess das Element Chlor, das als Verunreinigung eingeschleppt wurde, zu einer Verlangsamung der Korrosionsreaktion führen kann (K. Shibue, M. Kumagai, M.-S. Kim: J. Japan Inst. Metals 57 (1992) 721-725). Die Mechanismen und der ursächliche Zusammenhang sind in diesem Fall allerdings nicht bekannt. Aufbauend auf dieser Beobachtung werden deshalb bei der vorgenannten Weiterbildung der Erfindung gezielt halogenhaltige Verbindungen während des pulvermetallurigschen Herstellungsgangs eingebracht. Im Falle des schmelzmetallurgischen Weges führt die Zugabe von Halogeniden nicht zum Erfolg, da letztere bei den hohen Temperaturen der schmelzflüssigen TiAl-Legierungen abdampfen und somit bei der Erstarrung nicht mehr in ausreichender Menge im Werkstoff vorhanden sind. Bei einer vorteilhaften Ausführungsform werden Metallhalogenide mit hohem Schmelzpunkt wie Molybdänchloride, Niobchloride und/oder Wolframchloride in Form von feinsten Pulvern zugegeben. Um eine negative Beeinflussung der Festigkeitseigenschaften zu vermeiden, sind Mengen von weniger als 1000 ppm empfehlenswert. Bei Verwendung hochschmelzender Metallhalogenide besteht die Möglichkeit, einen sog. "Reservoireffekt" einzustellen. Dabei liegen die eingebrachten Halogenide in dispergierter Form vor und geben unter Betriebsbedingungen die für die Erhöhung der Korrosionsbeständigkeit notwendigen Halogene über einen längeren Zeitraum verteilt in dosierter Form ab. Auf diese Weise kann ein Langzeiteffekt bezüglich der Korrosionsbeständigkeit erreicht werden.

Die Halogene bzw. Halogenide können entweder durch Halogenierung des Metallpulvers über die Gasphase oder die flüssige Phase oder aber durch Einmischen von feinsten Halogenidpartikeln in das Legierungspulver eingebracht werden. Anschießend erfolgt der Pulververdichtungsprozess, der in der Regel auch eine thermische Behandlung einschließt und über eventuelle weitere Schritte zum endgültigen Werkstoff bzw. Bauteil führt.

Das Ergebnis des beschriebenen Verfahrens ist, dass zwar in der Anfangsphase der Korrosion des späteren Hochtemperatureinsatzes der Werkstoffe sowohl das schnellwachsende nichtschützende Titanoxid als auch das langsamwachsende schützende Aluminiumoxid gleichzeitig entstehen; nach einer kurzen Inkubationszeit bildet sich aber dann eine geschlossene Aluminiumoxidteildeckschicht in der Oxidschicht auf dem Werkstoff aus, die den Korrosionsprozess auf sehr niedrige Geschwindigkeiten verlangsamt und somit den korrosionsbedingten Metallabtrag signifikant reduziert. Diese Wirkung erlaubt den langzeitigen Einsatz von TiAl-Legierungen auch bei Temperaturen oberhalb von 700°C, ohne dass es zu einer schnellen Abnahme des tragenden Metallquerschnitts durch die Korrosionsreaktion kommt.

### Beispiel:

Es wurden je eine Legierung vom Typ Ti48AL2Cr (Atom%) einmal ohne Halogene und einmal mit ca. 500 ppm Chlor auf dem pulvermetallurgischen Wege hergestellt. Für erstere Legierung wurde aus der Schmelze verdüstes Pulver verwendet. Im zweiten Fall lag mechanisch legiertes Pulver vor, das aus einer schmelzmetallurgisch hergestellten Vorlegierung vom Typ TiAl65Cr2 und Titan mit einem Chlorgehalt von ca. 1000 ppm gefertigt worden war. Die Verdichtung erfolgte über gekapseltes Strangpressen bei Temperaturen oberhalb von 1000°C.

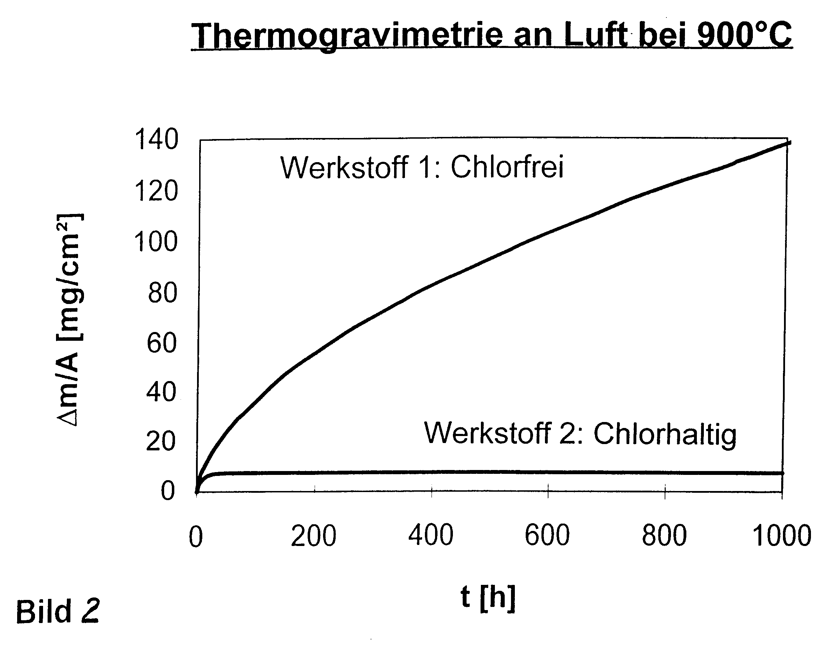

Anschließend wurde zur Prüfung der Oxidationsbeständigkeit ein Oxidationsversuch an Luft bei 900°C durchgeführt, in dem eine kontinuierliche Messung der Massenzunahme erfolgte. Die Aufheizrate auf die isotherme Oxidationstemperatur betrug 10 K/min. In Bild 2 sind die Massenzunahmen als Folge der Oxidation bei 900°C an Luft von Proben des halogenfreien Werkstoffs sowie einer Werkstoffprobe gemäß der Erfindung aufgetragen. Die Probe 1 ohne Halogenzusätze zundert stark und besitzt eine flächenbezogene Massenzunahme von 138 mg/cm² nach 1000 h. Die Probe 2 mit Chlorzusatz besitzt eine anfängliche flächenbezogene Massenzunahme von 7,4 mg/cm² nach ca. 20 h. Bis 1000 h steigt die flächenbezogene Massenzunahme dann nur noch auf 7,55 mg/cm² an. Dieses Oxidationsverhalten entspricht dem einer Deckschicht mit Barrierewirkung und steht für eine ausgeprägte Oxidationsbeständigkeit des Werkstoffs. Es kommt somit durch die Behandlung gemäß dem Verfahren der Erfindung zu einer signifikanten Verbesserung des Oxidationsverhaltens.

In weiteren Untersuchungen, die die Grundlage für den Anspruch 10 bilden, wurde die Werkstoffoberfläche mit Chlorionen implantiert. Bei Wahl der richtigen Dosis, Energie und Implantierzeit konnte eine Erhöhung der Oxidationsbeständigkeit erzielt werden, die mindestens derjenigen nach den vorangehenden Ansprüchen entsprach.

Das Ergebnis der Werkstoffoberflächenbehandlung mit dem Verfahren der Ionenimplantation ist offenbar, dass sich während der Oxidation bei hohen Temperaturen (diese Situation steht für den Einsatz der Werkstoffe bei hohen Temperaturen) eine geschlossene Aluminiumoxid(-teil-)deckschicht auf dem Werkstoff ausbildet, die den Korrosionsprozess auf sehr niedrige Geschwindigkeiten verlangsamt und somit den korrosionsbedingten Metallabtrag signifikant reduziert. Diese Wirkung erlaubt den langzeitigen Einsatz von TiAl-Legierungen auch bei Temperaturen oberhalb von 700°C, ohne dass es zu einer schnellen Abnahme des tragenden Metallquerschnitts durch die Korrosionsreaktion kommt.

### Beispiel:

Proben aus TiAl48.3Cr1.5 (at.-%), die aus nach dem Kupferkokillenschleudergussverfahren hergestellten Stangen präpariert waren, wurden mit Chlorionen implantiert. Zuvor waren die Probenoberflächen mit Schleifpapier bis zu einer Körnung von 4000 auf Spiegelglanz geschliffen worden. Drei unterschiedliche Implantationsvarianten wurden gewählt:
1) Dreistufige Implantation mit den jeweiligen Kombinationen Energie/Dosis von
   1MeV/3x10¹⁵ C1⁺cm⁻² (1. Stufe),
   2MeV/4x10¹⁵ C1⁺cm⁻² (2. Stufe) und
   4MeV/5x10¹⁵ C1⁺cm⁻² (3. Stufe)
2) Einstufige Implantation mit der Kombination Energie/Dosis von
   1MeV/1x10¹⁶ C1⁺cm⁻²
3) Dreistufige Implantation mit den jeweiligen Kombinationen Energie/Dosis von
   1MeV/6x10¹⁵ C1⁺cm⁻² (1. Stufe),
   2MeV/8x10¹⁵ C1⁺cm⁻² (2. Stufe) und
   4MeV/1x10¹⁶ C1⁺cm⁻² (3. Stufe).

Die Proben besaßen Couponform und wurden jeweils nur auf einer Seite implantiert.

Anschließend wurden die Proben an Luft bei 900°C für 300 h isotherm oxidiert. Nach der Oxidation zeigte sich, dass auf den nicht implantierten Flächen die erwartete schnelle Oxidation mit der Bildung dicker Oxidschichten stattgefunden hatte. Für die implantierte Fläche war es im Falle der Variante 1 zu einer deutlichen Verbesserung der Oxidationsbeständigkeit gekommen. Der überwiegende Anteil dieser Fläche wies eine sehr dünne (vermutlich aus Al₂O₃ bestehende) Oxidschicht auf . An einigen wenigen Stellen wurden Pusteln aus schnellerwachsenden Oxiden beobachtet. Für die Variante 2 und 3 lag auf den implantierten Flächen eine gegenüber Variante 1 weiter erhöhte Oxidationsbeständigkeit vor. Pusteln aus schnellerwachsenden Oxiden wurden hierbei nicht beobachtet. Es bildete sich vielmehr eine sehr dünne gleichmäßige Oxidschicht aus.

## Patentansprüche

1. Verfahren zur Erhöhung der Korrosionsbeständigkeit von Legierungen auf der Basis TiAl, **dadurch gekennzeichnet**, dass Halogene und oder halogenhaltige Verbindungen über die Gasphase oder Flüssigkeitsphase zumindest auf die Werkstoffoberfläche übertragen werden.

2. Verfahren nach Anspruch 1, **dadurch gekennzeichnet**, dass gasförmige Halogene und/oder halogenhaltige Verbindungen in einem erforderlichenfalls beheizten Reaktor über die Werkstoffoberfläche geleitet werden.

3. Verfahren nach den Ansprüchen 1 und 2, **dadurch gekennzeichnet**, dass feste, chloridhaltige Substanzen am Eingang oder im Inneren des Reaktors erhitzt werden, wodurch flüchtige halogenhaltige Spezies freigesetzt werden, die über Gasphasentransport zur Oberfläche des nach dem Verfahren zu behandelnden Werkstoffs gelangen.

4. Verfahren nach den Ansprüchen 1 bis 3, **dadurch gekennzeichnet**, dass über die Gasphase die Refraktärmetallchloride Wolframchlorid, Molybdänchlorid und/oder Niobchlorid auf die Werkstoffoberfläche aufgebracht werden.

5. Verfahren nach den Ansprüchen 1 bis 4, **dadurch gekennzeichnet**, dass neben halogenhaltigen Spezies auch sauerstoffhaltige Spezies in der Atmosphäre vorhanden sind und einem Voroxidationsprozess bei erhöhten Temperaturen beide Spezies mit der Werkstoffoberfläche reagieren.

6. Verfahren nach einem oder mehreren der Ansprüche 1, 2, 4 und 5, **dadurch gekennzeichnet**, dass für die Übertragung der halogenhaltigen Spezies PVD- oder CVD-Prozesse zum Einsatz kommen.

7. Verfahren nach Anspruch, **dadurch gekennzeichnet**, dass die Halogene und/oder halogenhaltige Verbindungen während eines pulvermetallurgischen Herstellungsprozesses der Legierung in den Werkstoff eingebracht und eines oder mehrere der Ausgangs- bzw. Legierungspulver der Halogenierung über die Gasphase oder Flüssigkeitsphase unterzogen werden.

8. Verfahren nach Anspruch 7, **dadurch gekennzeichnet**, dass die Ausgangs- bzw. Legierungspulver mit festen chlorhaltigen Phasen vermischt werden.

9. Verfahren nach den Ansprüchen 7 oder 8, **dadurch gekennzeichnet**, dass das die Refraktärmetallchloride Wolframchlorid, Molybdänchlorid und/oder Niobchlorid verwendet werden.

10. Verfahren nach Anspruch 1, **dadurch gekennzeichnet**, dass die Halogene über den Vorgang der Ionenimplantation bei beliebigen Temperaturen in einer oder mehreren Stufen in die Werkstoffoberfläche übertragen werden.
